# EUROPEAN PATENT APPLICATION

(11) **EP 4 580 000 A1**
(43) Date of publication of application: **02.07.2025**
(21) Application number: 23860756.8
(22) Date of filing: 21.08.2023
(51) Int. Cl.: H02J 50/00, H02J 50/10, H05K 7/20

(54) **WIRELESS POWER TRANSMISSION DEVICE**

(30) Priority: 29.08.2022 KR 20220108735; 07.10.2022 KR 20220128980
(71) Applicant: Samsung Electronics Co., Ltd., Suwon-si, Gyeonggi-do 16677 (KR)
(72) Inventor: KIM, Yusu, Suwon-si Gyeonggi-do 16677 (KR)
(74) Representative: Gulde & Partner
(86) International application number: PCT/KR2023/012362
(87) International publication number: WO 2024/049078

(57) **Abstract**

A wireless power transmission device can be provided. The wireless power transmission device may comprise: a housing including a front plate and a frame, which surrounds at least a part of the front plate and includes an edge area including a plurality of valleys and a plurality of mountains; a transmission coil arranged below the front plate; a magnetic body, which is arranged below the front plate, surrounds at least a part of the transmission coil, and is spaced apart from the frame; and a fan positioned below the magnetic body.

## Description

### [Technical Field]

The disclosure relates to wireless power transmission devices.

### [Background Art]

Wireless charging technology uses wireless power transmission/reception, and is a technology that is capable of charging the battery of an electronic device (e.g., a mobile phone) without connecting a separate charging connector. The absence of a connector for connecting to an external device may enhance the waterproof function.

The wireless power transmission device may transfer power using one or more of an inductive coupling scheme based on an electromagnetic induction phenomenon by the wireless power signal and an electromagnetic resonance coupling scheme based on an electromagnetic resonance phenomenon by the wireless power signal of a specific frequency.

An electronic device that supports wireless charging power reception may receive power from an external device through a coil and charge a battery using the input power. An electronic device that supports wireless charging power transmission may supply wireless power to another electronic device using the power from the battery or power input from a connected wired charger. For example, the wireless charging power transmission device may generate designated power using the power from an external device (e.g., a TA adapter) or a battery and supply the generated power to the other electronic device (e.g., a smartphone, a smart watch, or a wireless earphone (e.g., true wireless stereo)) through the coil.

### [Detailed Description of the Invention]

### [Technical Problem]

According to an embodiment of the disclosure, a wireless power transmission device may comprise a housing including a upper enclosure and a frame surrounding at least a portion of the upper enclosure and including an edge area including a plurality of valleys and a plurality of mountains, a transmission coil disposed below the upper enclosure, a magnetic body disposed below the upper enclosure, surrounding at least a portion of the transmission coil, and spaced apart from the frame, and a fan positioned below the magnetic body.

According to an embodiment of the disclosure, a wireless power transmission device may comprise a housing including an upper enclosure and a frame surrounding at least a portion of the upper enclosure, a transmission coil disposed below the upper enclosure, a magnetic body surrounding at least a portion of the transmission coil and spaced apart from the transmission coil, and a fan disposed below the transmission coil. The frame may include an edge area including a plurality of mountains and a plurality of valleys. The fan may be configured to transfer air to an outside of the wireless power transmission device through a second empty space formed by the plurality of valleys and the plurality of mountains and a first empty space between the magnetic body and the housing.

### [Brief Description of the Drawings]

FIG. 1 is a block diagram illustrating a wireless power transmission device and a wireless power reception device according to an embodiment of the disclosure;
FIG. 2 is a block diagram illustrating a wireless power transmission device according to an induction scheme and an electronic device receiving wireless power according to an embodiment of the disclosure;
FIG. 3 is a perspective view illustrating a wireless power transmission device and an electronic device receiving wireless power according to an embodiment of the disclosure;
FIG. 4 is an exploded perspective view illustrating a wireless power transmission device according to an embodiment of the disclosure;
FIG. 5 is an exploded perspective view illustrating a wireless power transmission device according to an embodiment of the disclosure;
FIG. 6 is an exploded perspective view illustrating a transmission assembly according to an embodiment of the disclosure;
FIG. 7 is a cross-sectional view illustrating a wireless power transmission device where the wireless power transmission device is positioned according to an embodiment of the disclosure;
FIG. 8 is a cross-sectional view illustrating a wireless power transmission device where the wireless power transmission device is positioned according to an embodiment of the disclosure;
FIG. 9 is a top view illustrating a frame according to an embodiment of the disclosure;
FIG. 10A is a top view illustrating a wireless power transmission device including a magnetic body, a ferrite, and an upper enclosure according to an embodiment of the disclosure; and
FIG. 10B is a view illustrating an air flow of a wireless power transmission device including a magnetic body, a ferrite, and an upper enclosure according to an embodiment of the disclosure.

### [Mode for Carrying out the Invention]

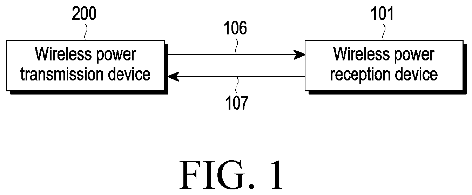

FIG. 1 is a block diagram illustrating a wireless power transmission device and a wireless power reception device according to an embodiment of the disclosure.

Referring to FIG. 1, a wireless power transmission device 200 may wirelessly transmit power 106 to a wireless power reception device 101. The wireless power transmission device 200 may receive information 107 from the wireless power reception device 101. For example, the wireless power transmission device 200 may transmit power 106 as per an induction scheme. Adopting the induction scheme, the wireless power transmission device 200 may include at least one of, e.g., a power source, a DC-DC conversion circuit (e.g., DC/DC converter), DC-AC conversion circuit (e.g., inverter), an amplifying circuit, an impedance matching circuit, at least one capacitor, at least one coil, or a communication modulation circuit. The at least one capacitor together with the at least one coil may constitute a resonance circuit. The wireless power transmission device 200 may be implemented in a scheme defined in the wireless power consortium (WPC) Qi standard. The wireless power transmission device 200 may include a coil that is capable of produce a magnetic field when letting an electric current flow thereacross by a induction scheme. The process of the wireless power transmission device 200 producing an induced magnetic field may be represented as the wireless power transmission device 200 wirelessly transmitting the power 106. Further, an induced electromotive force (or current, voltage, and/or power) may be generated by the magnetic field generated around the coil of the wireless power reception device 101. The process of producing an induced electromotive force through the coil may be represented as the 'wireless power reception device 101 wirelessly receives the power 106.'

The wireless power transmission device 200 according to an embodiment may communicate with the wireless power reception device 101. For example, the wireless power transmitting device 200 may communicate with the wireless power reception device 101 according to an in-band scheme. The wireless power transmitting device 200 may modulate data to be transmitted according to, e.g., a frequency shift keying (FSK) modulation scheme, and the wireless power reception device 101 may perform modulation according to an amplitude shift keying (ASK) modulation scheme, thereby providing information 107. The wireless power transmitting device 200 may identify the information 107 provided by the wireless power reception device 101 based on the amplitude of the current and/or voltage applied to the transmission coil. In FIG. 1, the wireless power reception device 101 is shown as directly transmitting the information 107 to the wireless power transmitting device 200, but this is merely for an easy understanding, and it will be appreciated by one of ordinary skill in the art that that the wireless power reception device 101 only controls on/off of at least one switch therein. The operation of performing modulation based on an ASK modulation scheme and/or FSK modulation scheme may be understood as the operation of transmitting data (or packets) according to the in-band communication scheme, and the operation of performing demodulation based on the ASK demodulation scheme and/or FSK demodulation scheme may be understood as the operation of receiving data (or packets) according to the in-band communication scheme. Meanwhile, data transmission/reception according to the in-band communication scheme is merely an example, and it will be appreciated by one of ordinary skill in the art that the wireless power transmission device 200 and the wireless power reception device 101 may transmit/receive data based on an out-of-band scheme (e.g., Bluetooth low energy (BLE) scheme or various short-range communication schemes).

In the disclosure, that the wireless power transmitting device 200 or the wireless power reception device 101 performs a specific operation may mean that various pieces of hardware included in the wireless power transmitting device 200 or the wireless power reception device 101, e.g., a controller (e.g., a micro-controlling unit (MCU), a field programmable gate array (FPGA), an application specific integrated circuit (ASIC), a microprocessor, or an application processor (AP)) performs the specific operation. Or, that the wireless power transmitting device 200 or the wireless power reception device 101 performs a specific operation may also mean that the connector controls another hardware device to perform the specific operation. That the wireless power transmitting device 200 or the wireless power reception device 101 performs a specific operation may mean that the controller or another hardware device triggers the specific operation as an instruction for performing the specific operation, which is stored in a storage circuit (e.g., a memory) of the wireless power transmitting device 200 or the wireless power reception device 101, is executed.

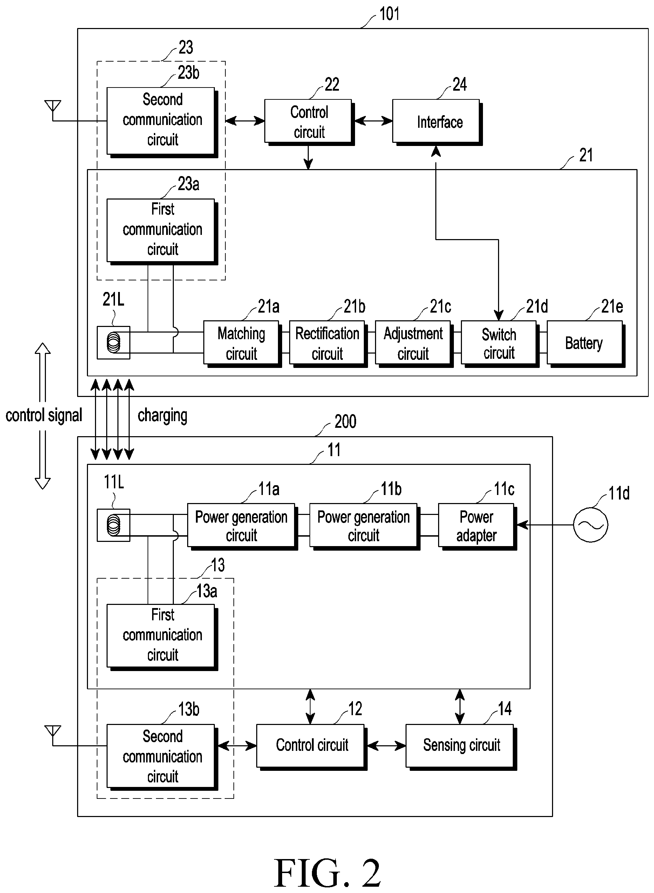

FIG. 2 is a block diagram illustrating a wireless power transmission device according to an induction scheme and an electronic device receiving wireless power according to an embodiment of the disclosure.

The wireless power transmission device 200 according to an embodiment of the disclosure may include at least one of a power transmission circuit 11, a control circuit 12, a communication circuit 13, or a sensing circuit 14. An electronic device 101 wirelessly receiving power may include at least one of a power reception circuit 21, a control circuit 22, a communication circuit 23, or an interface 24.

The power transmission circuit 11 according to an embodiment of the disclosure may provide power to the electronic device 101. The power transmission circuit 11 may include a power adapter 11c, a power generation circuit 11b, a matching circuit 11a, a coil (or conductive pattern) 11L, or a first communication circuit 13a. The power transmission circuit 11 may be configured to wirelessly transmit power to the electronic device 101 through the coil 11L. The power transmission circuit 11 may receive power from the outside in the form of a DC waveform or an AC waveform, and may supply the received power to the electronic device 101 in the form of an AC waveform. The coil 11L may include a plurality of coils and/or coils wound multiple times.

The power adapter 11c may receive AC or DC power from the outside, or may receive a power signal of a built-in battery device and output the same as DC power having a set voltage value. According to an embodiment, the power adapter 11c may be electrically connected to the power supply unit 11d positioned outside. For example, a cable of the power supply unit 11d may be directly connected to the power adapter 11c having a terminal. The voltage value of the DC power output from the power adapter 11c may be controlled by the control circuit 12. The DC power output from the power adapter 11c may be output to the power generation circuit 11b.

The power generation circuit 11b may convert a DC current output from the power adapter 11c into an AC current and output the AC current. The power generation circuit 11b may include a predetermined amplifier (not shown). If the DC voltage or current input through the power adapter 11c is less than a set gain, it may be amplified to a set value using the amplifier. The power generation circuit 11b may include a circuit for converting a DC current input from the power adapter 11c into an AC based on a control signal input from the control circuit 12. The power generation circuit 11b may include a bridge circuit including a plurality of switches. The coil 11L may include a plurality of coils (or coils wound multiple times), and the plurality of coils (or coils wound multiple times) may share at least a portion of the power generation circuit 11b. This is described below in greater detail. For example, the power generation circuit 11b may convert the DC current into AC through a predetermined inverter. The power generation circuit 11b may include a gate driving device (not shown). The gate driving device may change the DC current to AC while controlling the DC current by turning on/off. Alternatively, the power generation circuit 11b may generate an AC power signal through a wireless power generator (e.g., an oscillator).

The matching circuit 11a may perform impedance matching. For example, if the AC signal output from the power generation circuit 11b is transferred to the coil 11L, an electromagnetic field may be formed in the coil 11L by the AC signal. In an embodiment, the AC signal may be provided only to some of the plurality of coils (or coils wound multiple times), which is described below in greater detail. The frequency band of the formed electromagnetic field signal may be adjusted by adjusting the impedance of the matching circuit 11a. The matching circuit 11a may control the output power transmitted to the electronic device 101 through the coil 11L to have high efficiency or high power by impedance adjustment. The matching circuit 11a may adjust impedance based on the control of the control circuit 12. The matching circuit 11a may include at least one of an inductor (e.g., a coil (or a conductive pattern)), a capacitor, or a switch device. The control circuit 12 may control the connection state with at least one of the inductor or the capacitor through the switch device, thereby performing impedance matching. At least one of the control circuit 12 or the control circuit 52 may be implemented as various circuits capable of performing computation such as a general-purpose processor such as a CPU, a minicomputer, a microprocessor, a micro controlling unit (MCU), a field programmable gate array (FPGA), or the like, but the type thereof is not limited.

If a current is applied to the coil 11L, the coil 11L may form a magnetic field for inducing or resonating a current in the electronic device 101. The first communication circuit 13a (e.g., a resonant circuit) may perform communication (e.g., data communication) in an in-band form using electromagnetic waves generated by the coil 11L.

The sensing circuit 14 may periodically or aperiodically measure a change in current/voltage applied to the coil 11L of the power transmission circuit 11. The wireless power transmission device 10 may change the amount of power to be transmitted according to a change in the current/voltage applied to the coil 11L. Alternatively, the sensing circuit 14 may periodically or aperiodically sense a temperature change in the wireless power transmission device 10. According to an embodiment, the sensing circuit 14 may include at least one of a current/voltage sensor or a temperature sensor.

The control circuit 12 may control to wirelessly transmit power to the electronic device 101 through the power transmission circuit 11. The control circuit 12 may control to wirelessly transmit or receive information from the electronic device 101 through the communication circuit 13. The control circuit 12 may calculate the amount of power received from the electronic device 101 based on the current or voltage measured by the sensing circuit 14.

According to an embodiment, the received information may include at least one of charging configuration information related to the battery state of the electronic device 101, power amount control information related to adjustment of the amount of power transmitted to the electronic device 101, environment information related to the charging environment of the electronic device 101, or time information about the electronic device 101.

The charging configuration information may be information related to the battery state of the electronic device 101 at a wireless charging time point between the wireless power transmission device 10 and the electronic device 101. For example, the charging configuration information may include at least one of a total battery capacity, a remaining battery capacity, a number of times of charging, a battery usage amount, a charging mode, a charging method, or a radio frequency band of the electronic device 101.

The power amount control information may be information for controlling the amount of initial power transmitted according to a change in the amount of power charged in the electronic device 101 during wireless charging between the wireless power transmission device 10 and the electronic device 101.

The environment information may be information obtained by measuring the charging environment of the electronic device 101 by the interface 24 of the electronic device 101, and may include, e.g., at least one of temperature data including at least one of the internal temperature or the external temperature of the electronic device 101, illuminance data indicating illuminance (brightness) around the electronic device 101, or sound data indicating sound (noise) around the electronic device 101.

The control circuit 12 may be controlled to generate or transmit power to be transmitted to the electronic device 101 based on the charging configuration information among the received information. Alternatively, the control circuit 12 may determine or change the amount of power transmitted to the electronic device 101 based on at least some of the received information(e.g., at least one of the power amount control information, environment information, or time information). Alternatively, the matching circuit 11a may be controlled to change the impedance.

The communication circuit 13 may communicate with the electronic device 101 in a predetermined manner. The communication circuit 13 may perform data communication with the communication circuit 23 of the electronic device 101. For example, the communication circuit 13 may unicast, multicast, or broadcast the signal.

According to an embodiment, the communication circuit 13 may include at least one of a first communication circuit 13a implemented as one piece of hardware with the power transmission circuit 11 to allow the wireless power transmission device 10 to perform communication in an in-band form, or a second communication circuit 13b implemented in hardware different from the power transmission circuit 11 to allow the wireless power transmission device 10 to perform communication in an out-of-band form.

According to an embodiment, if the communication circuit 13 includes the first communication circuit 13a capable of performing communication in an in-band form, the first communication circuit 13 may receive the frequency and the signal level of an electromagnetic field signal received through the coil 11L of the power transmission circuit 11. The control circuit 12 may extract information received from the electronic device 101 by decoding the frequency and the signal level of the received electromagnetic field signal. Alternatively, the first communication circuit 13 may apply a signal for information about the wireless power transmission device 10 to be transmitted to the electronic device 101 to the coil 11L of the power transmission circuit 11, or may add a signal for information about the wireless power transmission device 10 to an electromagnetic field signal generated when a signal output from the matching circuit 11a is applied to the coil 11L and transmit the same to the electronic device 101. The control circuit 12 may control to change the state of connection to at least one of the inductor or capacitor of the matching circuit 11a and output it through on/off control of the switch device included in the matching circuit 11a.

According to an embodiment, if the communication circuit 13 includes a second communication circuit 13b capable of performing communication in an out-of-band form, the second communication circuit 13b may perform communication with the communication circuit 23 of the electronic device 101 using near-field communication (NFC), Zigbee communication, infrared communication, visible light communication, Bluetooth communication, or a Bluetooth low energy (BLE) scheme.

The above-described communication scheme of the communication circuit 13 is merely an example, and the scope of embodiments of the disclosure are not limited to a specific communication scheme performed by the communication circuit 13.

According to an embodiment of the disclosure, the electronic device 101 may include a power reception circuit 21, a control circuit 22, a communication circuit 23, or an interface 24. The power reception circuit 21 of the electronic device 101 may receive power from the power transmission circuit 11 of the wireless power transmission device 10. The power reception circuit 21 may be implemented in the form of a built-in battery, or may be implemented in the form of a power reception interface to receive power from the outside. The power reception circuit 21 may include a matching circuit 21a, a rectification circuit 21b, an adjustment circuit 21c, a switch circuit 21d, a battery 21e, or a coil 21L.

The power reception circuit 21 may receive wireless power in the form of electromagnetic waves generated corresponding to the current/voltage applied to the coil 11L of the power transmission circuit 11 through the coil 21L. For example, the power reception circuit 21 may receive power using the electromotive force formed in the coil 11L of the power transmission circuit 11 and the coil 21L of the power reception circuit 21.

The matching circuit 21a may perform impedance matching. For example, power transmitted through the coil 11L of the wireless power transmission device 10 may be transferred to the coil 21L to form an electromagnetic field. The matching circuit 21a may adjust the frequency band of the formed electromagnetic field signal by adjusting the impedance. By adjusting the impedance, the matching circuit 21a may control the input power received from the wireless power transmission device 10 through the coil 21L to have high efficiency and high output. The matching circuit 21a may adjust impedance based on the control of the control circuit 22. The matching circuit 21a may include at least one of an inductor (e.g., a coil (or a conductive pattern)), a capacitor, or a switch device. The control circuit 22 may control a connection state with at least one of the inductor or the capacitor through the switch device, thereby performing impedance matching.

The rectification circuit 21b may rectify the wireless power received by the coil 21L in the form of DC, and may be implemented in the form of, e.g., a bridge diode.

The adjustment circuit 21c may convert the rectified power to a set voltage or current. The adjustment circuit 21c may include a DC/DC converter (not shown). For example, the adjustment circuit 21c may convert the rectified power so that the voltage of the output terminal becomes 5V. Alternatively, a minimum value or a maximum value of a voltage that may be applied may be set at the front end of the adjustment circuit 21c.

The switch circuit 21d may connect the adjustment circuit 21c and the battery 21e. The switch circuit 21d may maintain an on/off state under the control of the control circuit 52.

The battery 21e may be charged by receiving power input from the adjustment circuit 21c. **In** another embodiment, a charger (not shown) may be further disposed between the switch circuit 21d and the battery 21e, and the charger (not shown) may change the voltage or current of power received in a predetermined mode (e.g., a constant current (CC) mode or a constant voltage (CV) mode) and charge the battery 21e. **In** various embodiments of the disclosure, the DC/DC converter of the adjustment circuit 21c may directly charge the battery 21e, or the charger (not shown) may adjust the power output from the adjustment circuit 21c once again to charge the battery 21e.

According to an embodiment, the electronic device 101 may include a sensing circuit, and the sensing circuit may sense a state change in the power received by the electronic device 101. For example, the sensing circuit may periodically or aperiodically measure the current/voltage value received in the coil 21L through a predetermined current/voltage sensor. The electronic device 101 may calculate the amount of power received by the electronic device 101 based on the measured current/voltage. The electronic device 101 may be utilized to change the matching circuit 21a based on the measured current/voltage.

According to an embodiment, the sensing circuit may sense a change in the charging environment of the electronic device 101. For example, the sensing circuit may periodically or aperiodically measure at least one of the internal temperature or the external temperature of the electronic device 101 through a predetermined temperature sensor.

The communication circuit 23 may communicate with the wireless power transmission device 10 in a predetermined manner. The communication circuit 23 may perform data communication with the communication circuit 13 of the wireless power transmission device 10. The communication circuit 23 may exchange a control signal through data communication with the wireless power transmission device 10. The communication circuit 23 may operate in the same or similar manner to the communication circuit 13 of the wireless power transmission device 10.

The control circuit 22 may transmit charging configuration information for receiving a required amount of power to the wireless power transmission device 10 based on information related to the battery state of the electronic device 101 through the communication circuit 23. For example, if the wireless power transmission device 10 capable of transmitting wireless power is identified, the control circuit 22 may transmit the charging configuration information for receiving a required amount of power to the wireless power transmission device 10 through the communication circuit 23 based on at least one of the total battery capacity, the remaining battery capacity, the number of times of charging, the battery usage, the charging mode, the charging scheme, or the radio reception frequency band of the electronic device 101.

The control circuit 22 may transmit the power amount control information for controlling the amount of power received from the wireless power transmission device 10 to the wireless power transmission device 10 according to a change in the amount of power charged in the electronic device 101, through the communication circuit 23. The first communication circuit 23a may include a switch, a capacitor, or a resistor. The control circuit 22 may turn on/off the switch according to the binary code of the data to be transmitted based on the on/off keying modulation scheme. The impedance sensed by the wireless power transmission device 10 may detect a change in the magnitude of power or the magnitude of current in the power transmission circuit 11 as the switch is turned on/off, and may be demodulated into a binary code so that data to be transmitted by the electronic device 101 may be obtained.

The electronic device 101 interface 24 may connect a TA (or an external electronic device) to the electronic device 101 through a connector. The interface 24 may include a USB communication module connected to the control circuit 22 or the processor through a designated system interface, e.g., an inter-integrated circuit (I2C). For example, the TA may communicate with the USB communication module of the wireless power reception device 101 through the CC terminal of the USB C type. According to an embodiment, the USB communication module may include a USB power delivery (PD) communication module for USB power delivery (PD) communication. According to an embodiment, the TA may be a TA supporting a programmable power supply (PPS) standard or a general TA not supporting the PPS. For example, the TA supporting the PPS may variously change or adjust the output TA voltage or the output TA current under the control of the control circuit 22 of the wireless power reception device 101. In the TA that does not support the PPS, the output TA voltage or the output TA current may be fixed. The interface 24 may be a wired interface.

Although FIG. 2 illustrates that the wireless power transmission device 10 and the electronic device 101 include only the power transmission circuit 11 and the power reception circuit 21, respectively, each of the wireless power transmission device 10 and the electronic device 101 may include both the power transmission circuit 11 and the power reception circuit 21. Accordingly, the wireless power transmission device 10 and the electronic device 101 according to an embodiment of the disclosure may function as both the power transmission device and the electronic device.

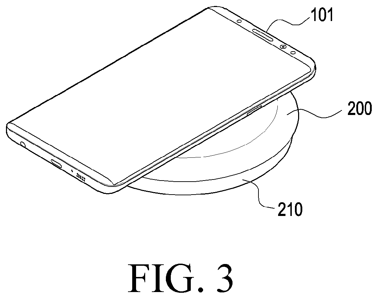

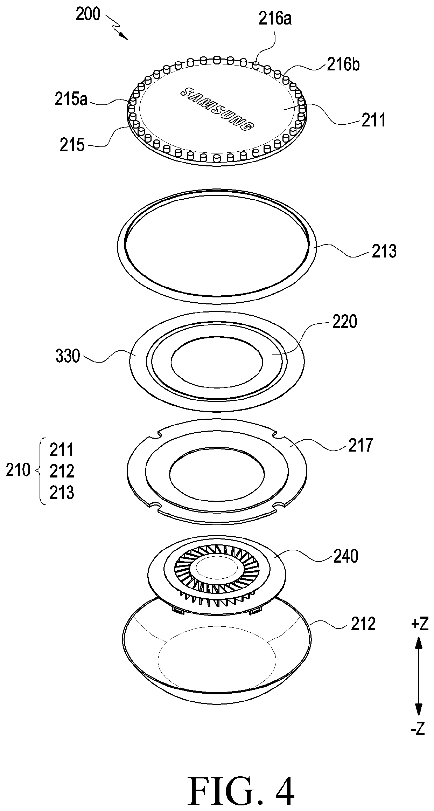

FIG. 3 is a perspective view illustrating a wireless power transmission device and an electronic device receiving wireless power according to an embodiment of the disclosure. FIG. 4 is an exploded perspective view illustrating a wireless power transmission device according to an embodiment of the disclosure.

Referring to FIGS. 3 and 4, the wireless power transmission device 200 may supply power to the adjacent wireless power reception device 101. The configuration of the wireless power transmission device 200 and the wireless power reception device 101 of FIGS. 3 and 4 may be identical in whole or part to the configuration of the wireless power transmission device 200 and the wireless power reception device 101 of FIGS. 1 and/or 2.

The wireless power transmission device 200 may include a housing 210 supporting the wireless power reception device 101. The housing 210 may receive a component (e.g., the magnetic body 330) inside the wireless power transmission device 200.

According to an embodiment, the housing 210 may include an upper enclosure 211. The upper enclosure 211 may be referred to as a front plate, an upper housing, an upper cover, a front cover, or an upper surface housing. The upper enclosure 211 may form at least a portion of the external appearance of the wireless power transmission device 200. For example, the upper enclosure 211 may form a front surface of the wireless power transmission device 200 and may face the wireless power reception device 101. The upper enclosure 211 may include an edge area 215 including an irregular pattern 215a. The irregular pattern 215a may be a portion of the edge area 215 protruding upward (+Z direction) of the edge area 215. According to an embodiment, the irregular pattern 215a may be referred to as a structure including a plurality of mountains 216a. According to an embodiment, due to the irregular pattern 215a, in a state in which the wireless power reception device 101 is disposed on the wireless power transmission device 200 (e.g., FIG. 2), there may be an empty space between the wireless power reception device 101 and the wireless power transmission device 200. For example, air in the empty space positioned between the wireless power reception device 101 and the wireless power transmission device 200 may flow to the outside through the surface of the wireless power reception device 101 and the groove 216b of the irregular pattern 215a.

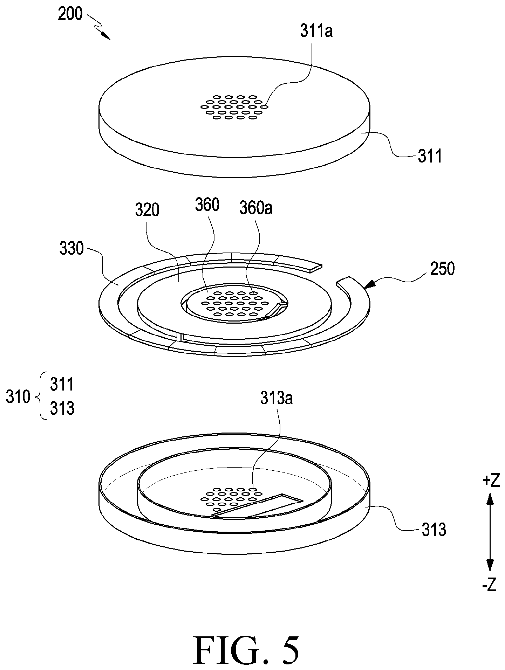

According to an embodiment, the upper enclosure 211 may include at least one first through hole (e.g., the first through hole 311a of FIG. 5). For example, the upper enclosure 211 may include the first through hole 311a together with the irregular pattern 215a.

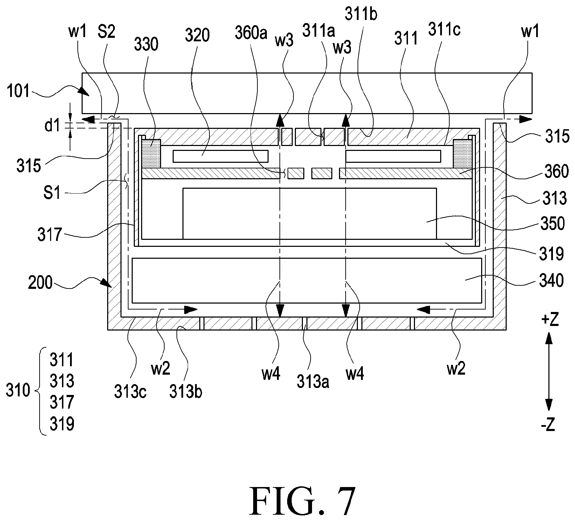

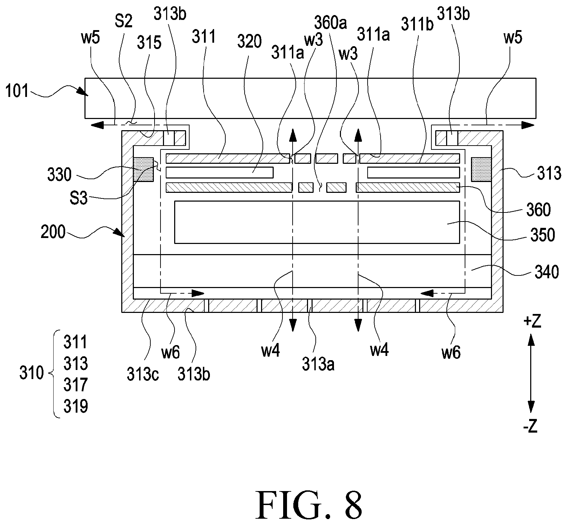

The shape of the irregular pattern 215a of the edge area 215 illustrated in FIG. 4 is selective. For example, FIG. 4 illustrates that the irregular pattern 215a has the plurality of mountains 216a protruding from the flat surface 216b, but the shape of the irregular pattern 215a is not limited thereto. For example, the irregular pattern 215a may have a substantially wavy surface. **In** FIG. 4, a structure in which the irregular pattern 215a protrudes upward (+Z direction) of the edge area 215 is disclosed, but the structure of the irregular pattern 215a is not limited thereto. For example, in an embodiment, the irregular pattern 215a may surround at least a portion of the upper enclosure 211. **In** an embodiment (e.g., FIG. 7), the irregular pattern 215a may protrude upward (+Z direction) from a portion (e.g., the frame 313) of the housing 310. In an embodiment (e.g., FIG. 8), the irregular pattern 215a may protrude upward (+Z direction) from a portion (e.g., the edge area 315) of the housing 310. According to an embodiment, the housing 210 may include a protection member 213 surrounding at least a portion of the upper enclosure 211. According to an embodiment, the protection member 213 may support or surround at least a portion of the edge area 215. According to an embodiment, the protection member 213 may be referred to as a deco member.

According to an embodiment, the housing 210 may include a rear case 212. The rear case 212 may form at least a portion of the external appearance of the wireless power transmission device 200. For example, the rear case 212 may form at least a portion of a side surface and at least a portion of a rear surface of the wireless power transmission device 200.

According to an embodiment, the housing 210 may include a supporting member 217. The supporting member 217 may support a component (e.g., the transmission coil 220 and/or the magnetic body 330) of the wireless power transmission device 200. The supporting member 217 may be positioned above (+Z) the rear case 212. According to an embodiment, the supporting member 217 may include a duct for guiding the flow of air generated by the fan 240.

According to an embodiment, the structure of the housing 210 is selective. For example, the shape of the protection member 213, the rear case 212, and/or the supporting member 217 may be changed according to the design of the wireless power transmission device 200. According to an embodiment, the protection member 213, the rear case 212, and/or the supporting member 217 may be referred to as a frame. According to an embodiment, at least a portion of the frame (e.g., the rear case 212, the protection member 213, and/or the supporting member 217) may be integrally formed with the upper enclosure.

According to an embodiment, the wireless power transmission device 200 may include a transmission coil 220. The transmission coil 230 may be identical in whole or part to the configuration of the coil 11L of FIG. 2. For example, the transmission coil 230 may form an electromagnetic field by an AC signal output from the power generation circuit 11b of FIG. 2.

According to an embodiment, the wireless power transmission device 200 may include a fan 240. According to an embodiment, the fan 240 may generate a flow of air for reducing the temperature of the wireless power transmission device 200 and/or the wireless power reception device 101. The fan 240 may be disposed inside the housing 210.

In the disclosure, the wireless power reception device 101 is illustrated as a smartphone, but this is selective. For example, the wireless power reception device 101 may be a portable electronic device including a smart watch, a wireless earphone, or a battery.

In the disclosure, the structure of the wireless power transmission device 200 is selective. For example, although FIG. 2 illustrates the wireless power transmission device 200 having a substantially cylindrical shape, the structure of the wireless power transmission device 200 is not limited thereto. The size of the wireless power transmission device 200 is selective. For example, the width of the wireless power transmission device 200 may be less than or equal to the width of the wireless power reception device 101.

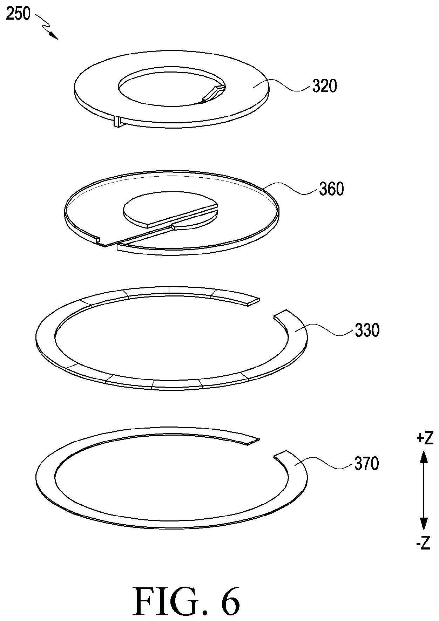

FIG. 5 is an exploded perspective view illustrating a wireless power transmission device according to an embodiment of the disclosure. FIG. 6 is an exploded perspective view illustrating a transmission assembly according to an embodiment of the disclosure.

Referring to FIGS. 5 and 6, the wireless power transmission device 200 may include a housing 310 (e.g., an upper enclosure 311 and a frame 313) and a power transmission module 250. The configuration of the wireless power transmission device 200 of FIG. 4 and/or FIG. 5 may be identical in whole or part to the configuration of the wireless power transmission device 200 of FIG. 1, FIG. 2, and/or FIG. 3. For example, the configuration of the upper enclosure 311 of FIG. 5 may be identical in whole or part to the configuration of the upper enclosure 311 of FIG. 4. The configuration of the frame 313 of FIG. 5 may be identical in whole or part to the configuration of the protection member 213, the rear case 212, and/or the supporting member 217 of FIG. 4.

According to an embodiment, the upper enclosure 311 may include at least one first through hole 311a. The inside of the wireless power transmission device 200 may communicate with the outside of the wireless power transmission device 200 through the first through hole 311a. The first through hole 311a may be an air hole penetrating the upper enclosure 311.

According to an embodiment, the frame 313 may include at least one second through hole 313a. The inside of the wireless power transmission device 200 may communicate with the outside of the wireless power transmission device 200 through the second through hole 313a. For example, the air inside the wireless power transmission device 200 may be transferred to the outside of the wireless power transmission device 200 through the second through hole 313a. Air outside the wireless power transmission device 200 may pass through the second through hole 313a and be sucked into the wireless power transmission device 200. The second through hole 313a may be an air hole penetrating the frame 313.

According to an embodiment, the edge area 315 may include at least one third through hole 313b. The inside of the wireless power transmission device 200 may communicate with the outside of the wireless power transmission device 200 through the third through hole 313b. For example, the air inside the wireless power transmission device 200 may be transferred to the outside of the wireless power transmission device 200 through the third through hole 313b. Air outside the wireless power transmission device 200 may pass through the third through hole 313b and be sucked into the wireless power transmission device 200. The third through hole 313b may be an air hole penetrating the edge area 315.

According to an embodiment, the wireless power transmission device 200 may include a power transmission module 250 for providing power to the wireless power reception device 101. The power transmission module 250 may be disposed in a space formed by the upper enclosure 311 and the frame 313. For example, the power transmission module 250 may be positioned between the upper enclosure 311 and the frame 313. The power transmission module 250 may be referred to as a power transmission assembly.

According to an embodiment, the power transmission module 250 may include a transmission coil 320. The configuration of the transmission coil 320 may be identical in whole or part to the configuration of the transmission coil 220 of FIG. 4. For example, if a current is applied, the transmission coil 320 may form a magnetic field for inducing or resonating the current.

According to an embodiment, the transmission coil 320 may have a closed curve shape. For example, air passing through a through hole (e.g., the first through hole 311a, the second through hole 313a, and/or the third through hole 360a) may flow to the inside or outside of the wireless power transmission device 200 through an empty space surrounded by the transmission coil 320.

According to an embodiment, the power transmission module 250 may include a magnetic body 330. According to an embodiment, the magnetic body 330 may guide the position of the wireless power transmission device 200 so that the transmission coil 320 of the wireless power transmission device 200 is positioned to correspond to the reception coil (e.g., the power reception circuit 21 of FIG. 2) of the wireless power reception device (e.g., the wireless power reception device 101 of FIG. 4). According to an embodiment, the wireless power reception device 101 may detect whether the wireless power transmission device 200 approaches by detecting the magnetic body 330. According to an embodiment, the magnetic body 330 may surround at least a portion of the transmission coil 320 and/or at least a portion of the ferrite 360.

According to an embodiment, the power transmission module 250 may include a ferrite 360. The ferrite 360 may be a component for increasing the strength of the magnetic field transferred to the wireless power reception device (e.g., the wireless power reception device 101 of FIG. 3). According to an embodiment, the ferrite 360 may include body centered cubic iron. According to an embodiment, the ferrite 360 may be referred to as a ferrite sheet or a magnetic field reinforcing member. According to an embodiment, the ferrite 360 may include at least one third through hole 360a. The inside of the wireless power transmission device 200 may communicate with the outside of the wireless power transmission device 200 through the third through hole 360a.

According to an embodiment, the power transmission module 250 may include a shielding member 370. The shielding member 370 may shield at least a portion of the magnetic field of the magnetic body 330. According to an embodiment, the shielding member 370 may be disposed below (-Z) the magnetic body 330. The shielding member 370 may surround at least a portion of the transmission coil 320 and/or at least a portion of the ferrite 360.

FIG. 7 is a cross-sectional view illustrating a wireless power transmission device according to an embodiment of the disclosure. FIG. 8 is a cross-sectional view illustrating a wireless power transmission device according to an embodiment of the disclosure.

Referring to FIG. 7 and/or FIG. 8, a wireless power transmission device 200 may include a housing 310, a transmission coil 320, a magnetic body 330, a fan 340, a circuit board 350, and/or a ferrite 360. The configuration of the housing 310, the transmission coil 320, the magnetic body 330, the fan 340, and the ferrite 360 of FIG. 7 and/or FIG. 8 may be identical in whole or part to the configuration of the housing 310, the transmission coil 320, the magnetic body 330, the fan 240, and the ferrite 360 of FIG. 4, FIG. 5, and/or FIG. 6.

According to an embodiment, the housing 310 may include an upper enclosure 311. The upper enclosure 311 may include a first surface 311b (e.g., an upper surface) to face the wireless power reception device 101 and a second surface 311c (e.g., a rear surface) opposite to the first surface 311b. The upper enclosure 311 may include at least one first through hole 311a penetrating the first surface 311b and the second surface 311c. The first through hole 311a may provide a path through which air flows for heat dissipation of the wireless power transmission device 200 and/or the power reception device 101. For example, at least a portion of the air outside the wireless power transmission device 200 may be transferred to the inside of the wireless power transmission device 200 through the first through hole 311a. At least a portion of the air inside the wireless power transmission device 200 may be transferred to the outside of the wireless power transmission device 200 through the first through hole 311a. For example, an air flow for heat dissipation of the wireless power transmission device 200 and/or the wireless power reception device 101 may be generated by the first through hole 311a. According to an embodiment, the first through hole 311a may be referred to as a first air hole.

According to an embodiment, the upper enclosure 311 may be formed in various shapes. According to an embodiment (e.g., FIG. 7), the upper enclosure 311 may be integrally formed with the sidewall structure 317. For example, the upper enclosure 311 may substantially surround some (e.g., the transmission coil 320 and the magnetic body 330) of the components of the wireless power transmission device 200. According to an embodiment (e.g., FIG. 8), the upper enclosure 311 may have a substantially flat plate shape.

According to an embodiment, the housing 310 may include a frame 313. The frame 313 may surround at least a portion of the upper enclosure 311. The frame 313 may receive components (e.g., the transmission coil 320, the magnetic body 330, the fan 340, and the ferrite 360) of the wireless power transmission device 200. The frame 313 may surround at least some of the components of the wireless power transmission device 200. According to an embodiment, the upper enclosure 311, the side wall structure 317, and/or the lower enclosure 319 may be surrounded by the frame 313. According to an embodiment, the configuration of the frame 313 may be identical in whole or part to the configuration of the rear case 212 of FIG. 4. For example, the frame 313 may be referred to as a portion of the housing 310 that forms at least a portion of the side surface and/or the rear surface of the housing 310.

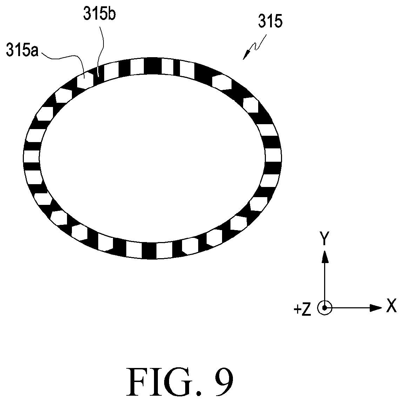

According to an embodiment, the frame 313 may include an edge area 315. According to an embodiment, the edge area 315 may be formed in a wavy pattern shape. For example, the edge area 315 may have a sine-shaped surface shape. The edge area 315 may include a plurality of mountains (e.g., the mountain 315a of FIG. 9) and a plurality of valleys (e.g., the valley 315b of FIG. 9). According to an embodiment, if the wireless power reception device 101 is disposed on the wireless power transmission device 200 (e.g., during charging), at least some of the mountains 315a may contact the wireless power reception device 101, and at least some of the valleys 315b may be spaced apart from the wireless power reception device 101.

According to an embodiment, the edge area 315 may provide a path of air for heat dissipation of the wireless power transmission device 200. For example, air passing through the second space S2 between the surface of the edge area 315 and the wireless power reception device 101 may disperse heat of the wireless power transmission device 200 and/or the wireless power reception device 101. For example, at least a portion of the air inside the wireless power transmission device 200 may be transferred to the outside of the wireless power transmission device 200 through a space (e.g., the second space S2) between the edge area 315 and the surface of the wireless power reception device 101. At least a portion of the air outside the wireless power transmission device 200 may be transferred to the inside of the wireless power transmission device 200 through the second space S2. The second space S2 may be an empty space formed by surfaces (e.g., the mountains 315a and the valleys 315b of FIG. 9) of the edge area 315.

According to an embodiment, the frame 313 may protrude further forward or upward (+Z direction) of the wireless power transmission device 200 than the upper enclosure 311. For example, the edge area 315 of the frame 313 may further protrude upward (+Z direction) by a first distance d1 than the first surface 311b of the upper enclosure 311.

According to an embodiment, the housing 310 may include a sidewall structure 317. The sidewall structure 317 may surround components (e.g., the transmission coil 320, the magnetic body 330, the fan 340, and the ferrite 360) of the wireless power transmission device 200. According to an embodiment, the sidewall structure 317 may extend from the upper enclosure 311. For example, the sidewall structure 317 may extend from the second surface 311c of the upper enclosure 311 downward (-Z direction) of the wireless power transmission device 200. According to an embodiment, at least a portion of the sidewall structure 317 may be referred to as a supporting member. The sidewall structure 317 may support components (e.g., the transmission coil 320, the magnetic body 330, the fan 340, and/or the ferrite 360) of the wireless power transmission device 200. According to an embodiment, the shape of the sidewall structure 317 may be changed according to the design of the wireless power transmission device 200, and may be excluded from some drawings (e.g., FIG. 8) for convenience of description.

According to an embodiment, the wireless power transmission device 200 may include a supporting member (e.g., 217) for supporting components (e.g., the transmission coil 320, the magnetic body 330, the fan 340, and/or the ferrite 360). For convenience of description, the supporting member 217 is excluded from FIG. 7. In an embodiment, the supporting member 217 may support the ferrite 360 in a state of being connected (e.g., screw-fastened) with a portion of the housing 310 under the ferrite 360 (-Z direction). In an embodiment, the supporting member 217 may support the ferrite 360 in a state of being connected (e.g., screw-fastened) with a portion of the housing 310 under the circuit board 350 (-Z direction).

According to an embodiment, the housing 310 may include a lower enclosure 319. The lower enclosure 319 may be surrounded by the sidewall structure 317. The lower enclosure 319 may extend from the sidewall structure 317. The lower enclosure 319 may be positioned between the fan 340 and the transmission coil 320. In an embodiment, the lower enclosure 319 may extend from a portion (e.g., the sidewall structure 317) of the housing 310 and may support an electronic component (e.g., the circuit board 350). For example, the fan 340 may be positioned between the lower enclosure 319 and the frame 313.

According to an embodiment, the lower enclosure 319 may include at least one through hole (not shown). The through hole formed in the lower enclosure 319 may provide a path through which air of the wireless power transmission device 200 flows.

According to an embodiment, the configuration of the upper enclosure 311 and/or the lower enclosure 319 is selective. For example, in an embodiment (not shown), the sidewall structure 317 and the lower enclosure 319 may be omitted. According to an embodiment, the wireless power transmission device 200 may be provided as an integral component. For example, at least one of the transmission coil 320, the fan 340, the circuit board 350, and/or the ferrite 360 may be connected to the frame 313. In the wireless power transmission device 200 provided as an integral component, the sidewall structure 317 and the lower enclosure 319 may be omitted.

According to an embodiment, the transmission coil 320 may be positioned below the upper enclosure 311. For example, the transmission coil 320 may be positioned below the second surface 311c of the upper enclosure 311.

According to an embodiment, the magnetic body 330 may be spaced apart from at least a portion of the housing 310. As the magnetic body 330 and the housing 310 are spaced apart from each other, at least a portion of the air inside the wireless power transmission device 200 may be transferred to the outside of the wireless power transmission device 200 through the space between the magnetic body 330 and the housing 310. According to an embodiment, the magnetic body 330 may be spaced apart from the transmission coil 320.

Referring to FIG. 7, the magnetic body 330 may be spaced apart from the frame 313. For example, the magnetic body 330 may be attached to or connected to the second surface 311c of the upper enclosure 311. The magnetic body 330 may be spaced apart from the frame 313 and may form a first space S1 through which air may pass. The first space S1 may be referred to as an empty space between the magnetic body 330 and the frame 313. The magnetic body 330 may surround at least a portion of the transmission coil 320.

Referring to FIG. 8, the magnetic body 330 may be spaced apart from the upper enclosure 311. For example, the magnetic body 330 may be disposed on the inner surface of the frame 313. The magnetic body 330 may be spaced apart from the upper enclosure 311 and may form a third space S3 through which air may pass. The third space S3 may be referred to as an empty space between the magnetic body 330 and the upper enclosure 311. The magnetic body 330 may surround at least a portion of the transmission coil 320 and/or at least a portion of the upper enclosure 311. According to an embodiment (e.g., FIG. 8), a portion of the edge area 315 may extend to overlap the upper enclosure 311.

According to an embodiment, the fan 340 may generate a flow of air for heat dissipation of the wireless power transmission device 200 and/or the wireless power reception device 101. According to an embodiment, the fan 340 may be referred to as a cooling fan.

According to an embodiment, the fan 340 may generate a flow of air upward (+Z direction), downward (-Z direction), and/or laterally of the wireless power transmission device 200.

Referring to FIG. 7, the fan 340 may transfer the air inside the wireless power transmission device 200 to the outside of the wireless power transmission device 200 or may transfer the air outside the wireless power transmission device 200 to the inside of the wireless power transmission device 200, through the first space S1 and the second space S2. As air flows into the wireless power transmission device 200, the temperature of the wireless power transmission device 200 may be reduced. As air is discharged to the outside of the wireless power transmission device 200, the temperature of the outside (e.g., the wireless power reception device 101) of the wireless power transmission device 200 may be reduced.

According to an embodiment, the fan 340 may generate a first air flow w1 that transfers at least a portion of the air inside the wireless power transmission device 200 to the outside of the wireless power transmission device 200 through the first space S1 and the second space S2. According to an embodiment, the fan 340 may generate a second air flow w2 that transfers at least a portion of the air outside the wireless power transmission device 200 to the inside of the wireless power transmission device 200 through the second space S2 and the first space S1.

Referring to FIG. 8, the fan 340 may transfer the air inside the wireless power transmission device 200 to the outside of the wireless power transmission device 200 or may transfer the air outside the wireless power transmission device 200 to the inside of the wireless power transmission device 200 ]through the second space S2 and the third space S3. According to an embodiment, the fan 340 may generate a fifth air flow w5 that transfers at least a portion of the air inside the wireless power transmission device 200 to the outside of the wireless power transmission device 200 through the second space S2 and the third space S3. According to an embodiment, the fan 340 may generate a sixth air flow w6 that transfers at least a portion of the air outside the wireless power transmission device 200 to the inside of the wireless power transmission device 200 through the third space S3 and the second space S2. According to an embodiment, the fifth air flow w5 and/or the sixth air flow w6 may pass through the third through hole 313b.

According to an embodiment, the fan 340 may transfer the air inside the wireless power transmission device 200 to the outside of the wireless power transmission device 200 or may transfer the air outside the wireless power transmission device 200 to the inside of the wireless power transmission device 200 through a through hole (e.g., the first through hole 311a, the second through hole 313a, and/or the third through hole 360a) of the wireless power transmission device 200. According to an embodiment, the fan 340 may receive air from the outside of the wireless power transmission device 200 through the second through hole 313a and may generate a third air flow w3 that transfers air to the outside (e.g., the wireless power reception device 101) of the wireless power transmission device 200 through the first through hole 311a and the third through hole 360a. According to an embodiment, the fan 340 may receive air through the first through hole 311a and the third through hole 360a, and may generate a fourth air flow w4 that transfers air to the outside of the wireless power transmission device 200 through the second through hole 313a.

According to an embodiment, the fan 340 may be provided as a modular component. For example, the fan 340 may be selectively assembled or attached to the wireless power transmission device 200. According to an embodiment, a portion (e.g., the frame 313) of the housing 310 receiving the fan 340 may be coupled to a portion (e.g., the upper enclosure 311, the sidewall structure 317, and/or the lower enclosure 319) of the housing 310 receiving components (e.g., the transmission coil 320, the circuit board 350, and/or the ferrite 360) for wireless charging.

According to an embodiment, the position where the fan 340 is disposed may be selectively designed. For example, in FIGS. 7 and 8, the fan 340 is disposed below (-Z) the circuit board 350, but the position of the fan 340 is not limited thereto. For example, in an embodiment, the fan 340 may be positioned between the ferrite 360 and the circuit board 350.

According to an embodiment, the sidewall structure 317 and/or the lower enclosure 319 may be excluded from the wireless power transmission device 200. For example, the sidewall structure 317 and/or the lower enclosure 319 may be excluded from the structure in which the fan 340 is provided as a component integrated with the wireless power transmission device 200.

According to an embodiment, the circuit board 350 may receive an electronic component (e.g., the power transmission circuit 11, the control circuit 12, the communication circuit 13, and/or the sensing circuit 14 of FIG. 2) for the operation of the wireless power transmission device 200. The circuit board 350 may receive a processor configured to control the power transmission circuit 11 to apply power to the transmission coil 320.

According to an embodiment, the circuit board 350 may be disposed in the housing 310. According to an embodiment, the circuit board 350 may be disposed above the fan 340 (+Z direction). The temperature of the electronic component received in the circuit board 350 may be reduced by the flow of air generated by the fan 340. For example, at least a portion of heat generated by the electronic component received in the circuit board 350 may be dispersed by the air flow (e.g., the third air flow w3 and/or the fourth air flow w4) generated by the fan 340. The position where the circuit board 350 is disposed is selective. For example, according to an embodiment (not shown), the circuit board 350 may be disposed below the fan 340 (in the -Z direction).

FIG. 9 is a top view illustrating an edge area according to an embodiment of the disclosure.

Referring to FIG. 9, the edge area 315 may include a plurality of mountains 315a and a plurality of valleys 315b. The configuration of the edge area 315 of FIG. 9 may be identical in whole or part to the configuration of the edge area 215 of FIG. 4. For example, the configuration of the mountains 315a and the valleys 315b of FIG. 9 may be identical in whole or part to the configuration of the mountains 216a and the valleys 216b of the irregular pattern 215a of FIG. 4.

According to an embodiment, the edge area 315 may have a curved shape for leading to an air flow. For example, the height (e.g., the length in the Z-axis direction) of the edge area 315 may be different for each portion. According to an embodiment, the edge area 315 may include a plurality of mountains 315a and a plurality of valleys 315b. According to an embodiment, the edge area 315 may be formed in a wavy pattern shape. For example, the height of the edge area 315 may have a sine-shaped or cosine-shaped surface. For example, the plurality of mountains 315a and/or the plurality of valleys 315b may have a curved surface. According to an embodiment, the shape of the mountain 315a and the valley 315b positioned in the edge area 315 may be various. For example, the mountain 315a and/or the valley 315b may have a wavy pattern or a straight line shape. Due to the shape of the mountain 315a and/or the valley 315b, the shape of the edge area 315 may be implemented in various ways.

The structure of the edge area 315 of FIG. 9 may be applied to the edge area 315 of the frame (e.g., the frame 313 of FIG. 7 and/or FIG. 8) described above.

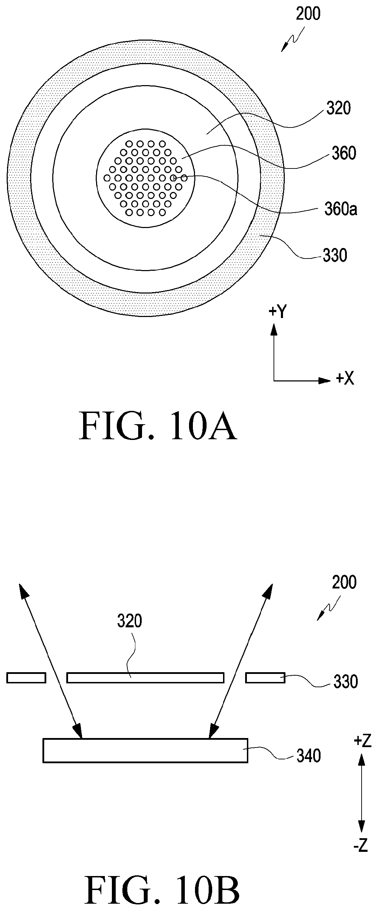

FIG. 10A is a top view illustrating a wireless power transmission device including a magnetic body, a ferrite, and an upper enclosure according to an embodiment of the disclosure. FIG. 10B is a view illustrating an air flow of a wireless power transmission device including a magnetic body, a ferrite, and an upper enclosure according to an embodiment of the disclosure.

Referring to FIG. 10A and/or FIG. 10B, a wireless power transmission device 200 may include a transmission coil 320, a magnetic body 330, a fan 340, and/or a ferrite 360.

The configuration of the transmission coil 320, the magnetic body 330, the fan 340, and/or the ferrite 360 of FIG. 10A and/or FIG. 10B may be identical in whole or part to the configuration of the transmission coil 320, the magnetic body 330, the fan 340, and/or the ferrite 360 of FIG. 7 and/or FIG. 8.

According to an embodiment, the magnetic body 330 may be spaced apart from the transmission coil 320. For example, the magnetic body 330 may surround at least a portion of the transmission coil 320 while being spaced apart from the transmission coil 320. At least a portion of the air generated by the fan 340 may be transferred to the outside of the wireless power transmission device 200 through a space (e.g., the third space S3 of FIG. 8) between the magnetic body 330 and the transmission coil 320.

According to an embodiment, the ferrite 360 may include a plurality of third through holes 360a. Referring to FIG. 10A, when the wireless power transmission device 200 is viewed from above (+Z direction), the third through hole 360a of the ferrite 360 may overlap the empty space 320a surrounded by the transmission coil 320. For example, the flow of air generated by the fan 340 may flow to the outside of the wireless power transmission device 200 through the third through hole 360a of the ferrite 360 and the empty space 320a surrounded by the transmission coil 320.

The structure of the wireless power transmission device 200 of FIG. 10A and/or FIG. 10B may be applied to the wireless power transmission device (e.g., the wireless power transmission device 200 of FIG. 7 and/or FIG. 8) described above.

When wireless power transmission is used, charging efficiency may be reduced due to heat generated in the power transmission circuit and/or the power reception circuit.

According to an embodiment of the disclosure, there may be provided a wireless power transmission device capable of reducing overheating of a wireless power transmission device and/or a wireless power reception device by dispersing the heat generated during wireless power transmission.

The disclosure is not limited to the foregoing embodiments but various modifications or changes may rather be made thereto without departing from the spirit and scope of the disclosure.

According to an embodiment of the disclosure, a wireless power transmission device (e.g., the wireless power transmission device 200 of FIG. 1) may comprise a housing (e.g., the housing 310 of FIG. 7) including a upper enclosure (e.g., the upper enclosure 311 of FIG. 7) and a frame (e.g., the frame 313 of FIG. 7) surrounding at least a portion of the upper enclosure and including an edge area (e.g., the edge area 315 of FIG. 7) including a plurality of valleys (e.g., the valley 315b of FIG. 9) and a plurality of mountains (e.g., the mountain 315a of FIG. 9), a transmission coil (e.g., the transmission coil 320 of FIG. 7) disposed below the upper enclosure, a magnetic body (e.g., the magnetic body 330 of FIG. 7) disposed below the upper enclosure, surrounding at least a portion of the transmission coil, and spaced apart from the frame, and a fan (e.g., the fan 340 of FIG. 7) positioned below the magnetic body.

According to an embodiment, the fan may be configured to discharge air inside the wireless power transmission device to an outside of the wireless power transmission device via a first space (e.g., the first space S1 of FIG. 7) between the frame and the magnetic body and a second space (e.g., the second space S2 of FIG. 7) formed by the plurality of valleys and the plurality of mountains or the fan is configured to suck air outside the wireless power transmission device into the wireless power transmission device via the second space and the first space. For example, air inside the wireless power transmission device may be transferred to an outside of the wireless power transmission device through the first space between the frame and the magnetic body and the second space formed by the plurality of valleys and the plurality of mountains, using the fan. For example, air outside the wireless power transmission device may be transferred to the inside of the wireless power transmission device through the second space formed by the plurality of valleys and the plurality of mountains and the first space between the frame and the magnetic body using the fan. As the air outside the wireless power transmission device which has a relatively low temperature is transferred to the inside of the wireless power transmission device, the temperature of the wireless power transmission device and/or the electronic device (e.g., the wireless power reception device) may be reduced.

According to an embodiment, the housing may include a sidewall structure (e.g., the sidewall structure 317 of FIG. 7) extending from the upper enclosure for containing the transmission coil and the magnetic body and a lower enclosure (e.g., the lower enclosure 319 of FIG. 7) connected to the sidewall structure. The frame may surround the sidewall structure.

According to an embodiment, the fan may be connected to the frame, and the fan may be positioned between the lower enclosure and the frame.

According to an embodiment, at least one of the transmission coil, the ferrite, the circuit board, and the fan may be connected to the frame.

According to an embodiment, the upper enclosure may include a first surface (e.g., the first surface 311b of FIG. 7) configured to face an external electronic device (e.g., the wireless power reception device 101 of FIG. 3) to receive power from the wireless power transmission device, a second surface (e.g., the second surface 311c of FIG. 7) opposite to the first surface, and at least one first through hole (e.g., the first through hole 311a of FIG. 7) penetrating the first surface and the second surface.

According to an embodiment, the frame may include at least one second through hole (e.g., the second through hole 313a of FIG. 7).

According to an embodiment, the wireless power transmission device may further comprise a ferrite (e.g., the ferrite 360 of FIG. 7) positioned below the transmission coil.

According to an embodiment, the ferrite may include at least one third through hole (e.g., the third through hole 360a of FIG. 7).

According to an embodiment, the edge area of the frame may protrude further forward (e.g., +Z direction of FIG. 7) of the wireless power transmission device than the first surface (e.g., the first surface 311b of FIG. 7) of the upper enclosure. As the edge area further protrudes than the first surface, a path through which air flows may be formed. As air flows, the maximum temperature of the wireless power transmission device and/or the wireless power reception device may be reduced, and charging efficiency may be increased.

According to an embodiment, the wireless power transmission device may comprise a power transmission circuit (e.g., the power transmission circuit 11 of FIG. 2) and a circuit board (e.g., the circuit board 350 of FIG. 7) receiving a processor configured to control the power transmission circuit to apply power to the transmission coil.

According to an embodiment, the fan may be positioned between the circuit board and the frame.

According to an embodiment, the fan may be positioned between the transmission coil and/or the ferrite and the circuit board.

According to an embodiment, the magnetic body may be spaced apart from the transmission coil.

According to an embodiment, the fan may be configured to generate an air flow configured to be transferred to the outside of the wireless power transmission device through at least one first through hole (e.g., the first through hole 311a of FIG. 7) of the upper enclosure, at least one second through hole (e.g., the second through hole 313a of FIG. 7) of the frame, and at least one third through hole (e.g., the third through hole 360a of FIG. 7) of the ferrite.

According to an embodiment, at least some of the plurality of mountains may be configured to contact the wireless power reception device (e.g., the wireless power reception device 101 of FIG. 7). The plurality of valleys may be configured to be spaced apart from the wireless power reception device. For example, when the wireless power reception device 101 is disposed on the wireless power transmission device 200 for charging, air may flow through the space between the plurality of valleys and the wireless power reception device.

According to an embodiment of the disclosure, a wireless power transmission device (e.g., the wireless power transmission device 200 of FIG. 1) may comprise a housing (e.g., the housing 310 of FIG. 5) including an upper enclosure (e.g., the upper enclosure 311 of FIG. 5) and a frame (e.g., the frame 313 of FIG. 5) surrounding at least a portion of the upper enclosure, a transmission coil (e.g., the transmission coil 320 of FIG. 5) disposed below the upper enclosure, a magnetic body (e.g., the magnetic body 330 of FIG. 5) surrounding at least a portion of the transmission coil and spaced apart from the transmission coil, and a fan (e.g., the fan 240 of FIG. 4) disposed below the transmission coil. The frame may include an edge area (e.g., the edge area 315 of FIG. 9) including a plurality of mountains (e.g., the mountain 315a of FIG. 9) and a plurality of valleys (e.g., the valley 315b of FIG. 9). The fan may be configured to transfer air to an outside of the wireless power transmission device through a second empty space (e.g., the second space S2 of FIG. 7 and/or FIG. 8) formed by the plurality of valleys and the plurality of mountains and a first empty space (e.g., the first space S1 of FIG. 7 and/or the third space S3 of FIG. 8) between the magnetic body and the housing.

According to an embodiment, the magnetic body may be connected to a rear surface (e.g., the second surface 311b of FIG. 7) of the upper enclosure. The first empty space may be a space (e.g., the first space S1 of FIG. 7) between the frame and the magnetic body.

According to an embodiment, the magnetic body may be attached to the frame. The first empty space may be a space (e.g., the third space S3 of FIG. 8) between the magnetic body and the enclosure.

According to an embodiment, the plurality of mountains of the edge area may protrude further forward of the wireless power transmission device than the front surface (e.g., the first surface 311b of FIG. 7 and/or FIG. 8) of the upper enclosure.

According to an embodiment, the fan may be configured to generate an air flow configured to be transferred to the outside of the wireless power transmission device through at least one first through hole (e.g., the first through hole 311a of FIG. 5) of the upper enclosure and at least one second through hole (e.g., the second through hole 313a of FIG. 5) of the frame.

It is apparent to one of ordinary skill in the art that the wireless power transmission device as described above are not limited to the above-described embodiments and those shown in the drawings, and various changes, modifications, or alterations may be made thereto without departing from the scope of the disclosure.

## Claims

1. A wireless power transmission device (200), comprising:
a housing (210, 310) including a front plate (211, 311) and a frame (313) surrounding at least a portion of the front plate and including an edge area (215, 315) including a plurality of valleys (216b, 315b) and a plurality of mountains (216a, 315a);
a transmission coil (220, 320) disposed below the front plate;
a magnetic body (330) disposed below the front plate, surrounding at least a portion of the transmission coil, and spaced apart from the frame; and
a fan (240, 340) positioned below the magnetic body.

2. The wireless power transmission device of claim 1, wherein the fan is configured to discharge air inside the wireless power transmission device to an outside of the wireless power transmission device via a first space (S1) between the frame and the magnetic body and a second space (S2) formed by the plurality of valleys and the plurality of mountains, or the fan is configured to suck air outside the wireless power transmission device into the wireless power transmission device via the second space and the first space.

3. The wireless power transmission device of claim 1 or 2, wherein the housing includes a sidewall structure (317) extending from the front plate for containing the transmission coil and the magnetic body, and a lower enclosure (319) connected to the sidewall structure, and
wherein the frame surrounds the sidewall structure.

4. The wireless power transmission device of claim 3, wherein the fan is connected to the frame, and the fan is positioned between the lower enclosure and the frame.

5. The wireless power transmission device of any one of claims 1 to 4, wherein at least one of the transmission coil and the fan is connected to the frame.

6. The wireless power transmission device of any one of claims 1 to 5, wherein the front plate includes a first surface (311b) configured to face an external electronic device for receiving power from the wireless power transmission device, a second surface (311c) opposite to the first surface, and at least one first through hole (311a) penetrating the first surface and the second surface.

7. The wireless power transmission device of any one of claims 1 to 6, wherein the frame includes at least one second through hole (313a).

8. The wireless power transmission device of any one of claims 1 to 7, further comprising a ferrite (360) positioned below the transmission coil.

9. The wireless power transmission device of claim 8, wherein the ferrite includes at least one third through hole (360a).

10. The wireless power transmission device of any one of claims 1 to 9, wherein the edge area of the frame protrudes further forward of the wireless power transmission device than the first surface (311b) of the front plate.

11. The wireless power transmission device of any one of claims 1 to 10, further comprising a circuit board (350) receiving a power transmission circuit (11) and a processor configured to control the power transmission circuit to apply power to the transmission coil.

12. The wireless power transmission device of claim 11, wherein the fan is positioned between the circuit board and the frame.

13. The wireless power transmission device of any one of claims 1 to 12, wherein the magnetic body is spaced apart from the transmission coil.

14. The wireless power transmission device of claim 7, wherein the fan is configured to generate an air flow configured to be transferred to an outside of the wireless power transmission device via at least one first through hole 311a of the front plate and at least one second through hole 313a of the frame.

15. The wireless power transmission device of any one of claims 1 to 14, wherein at least some of the plurality of mountains are configured to contact the wireless power reception device, and at least some of the plurality of valleys are configured to be spaced apart from the wireless power reception device.
